# FASCICULE DE BREVET EUROPEEN

(11) **EP 3 443 602 B1**
(45) Date de publication et mention de la délivrance du brevet: **21.10.2020**
(21) Numéro de dépôt: 17721787.4
(22) Date de dépôt: 14.04.2017
(51) Int. Cl.: H01L 41/47, H01L 41/00, H01L 41/06, H01L 41/12

(54) **GENERATEUR D'ELECTRICITE COMPRENANT UN CONVERTISSEUR MAGNETO-ELECTRIQUE**
EIN STROMGENERATOR MIT EINEM MAGNETOELEKTRISCHEN WANDLER
ELECTRICITY GENERATOR COMPRISING A MAGNETOELECTRIC CONVERTER

(30) Priorité: 15.04.2016 FR 1653359
(43) Date de publication de la demande: 20.02.2019
(73) Titulaire: Enerbee, 38040 Grenoble (FR)
(72) Inventeur: DELAMARE, Jérôme, 38950 Quaix-en-Chartreuse (FR); RICART, Thibault, 38170 Seyssinet Pariset (FR); GUILLEN, Jérémie, 38100 Grenoble (FR)
(74) Mandataire: IP Trust
(86) Numéro de dépôt international: PCT/FR2017/050906
(87) Numéro de publication internationale: WO 2017/178773

(56) Documents cités:
- WO-A1-2015/059421

## Description

### DOMAINE DE L'INVENTION

La présente invention concerne le domaine des dispositifs pour la récupération d'énergie. Elle concerne en particulier un générateur d'électricité et un convertisseur apte à convertir une variation d'énergie magnétique en une différence de potentiel, ainsi qu'un procédé de fabrication associé. Le convertisseur magnéto-électrique comprend un empilement de couches de matériaux magnétostrictif et piézoélectrique.

### ARRIERE PLAN TECHNOLOGIQUE DE L'INVENTION

La magnétostriction correspond, en général, à un échange réversible d'énergie d'une forme mécanique à une forme magnétique. L'effet le plus connu relatif à la magnétostriction est l'effet Joule. Il correspond à l'expansion, dans le cas d'un coefficient de magnétostriction positif, ou à la contraction, dans le cas d'un coefficient négatif, d'un barreau ferromagnétique sous l'influence d'un champ magnétique. En l'absence de champ magnétique, le barreau revient théoriquement à sa forme initiale. Dans le cas d'une expansion longitudinale dans le sens du champ magnétique, une contraction apparaît dans les directions transversales de manière à conserver le volume du barreau sensiblement constant.

La piézoélectricité correspond à la génération de charges électriques sous l'influence d'une contrainte mécanique. Parmi les matériaux piézoélectriques, on connaît notamment le PZT (alliage de Plomb, Zirconium et Titane). Le PZT, muni de deux électrodes, peut être pré-polarisé, grâce à un traitement thermique à une température sensiblement inférieure à sa température de Curie, pendant lequel une tension est appliquée aux électrodes. L'axe de polarisation du matériau est alors établi selon une direction allant de l'une à l'autre des électrodes. Cette polarisation détermine notamment sur quelle électrode va apparaître un excédent de charges électriques en réponse à une contrainte appliquée au matériau piézoélectrique. En considérant une couche de matériau PZT, comportant une face supérieure et une face inférieure parallèles, l'axe de polarisation peut être orienté selon une direction perpendiculaire aux faces du fait de la présence d'une électrode sur chaque face. Alternativement, l'axe de polarisation peut être orienté selon une direction parallèle aux faces, en utilisant notamment des électrodes inter-digitées sur au moins l'une des deux faces de la couche. Dans ce dernier cas, l'axe de polarisation est parallèle au plan des faces et perpendiculaire aux doigts de matériau conducteur formant les électrodes interdigitées. Pour convertir une contrainte / déformation en différence de potentiel aux bornes des électrodes, on peut donc se placer dans l'un des deux modes particuliers selon que la déformation est perpendiculaire à l'axe de polarisation (mode appelé d₃₁) ou selon que la déformation est parallèle à l'axe de polarisation (mode appelé d₃₃).

On connaît de l'état de la technique (WO2015/059421 ou encore article de T.Lafont et al, « Magnetostrictive-piezoelectric composite structures for energy harvesting », Journal of Micromechanics and Microengineering, n°22, 2012), des générateurs d'électricité comportant une source de champ magnétique dont les lignes de champ sont parallèles à un plan de référence, et un convertisseur magnéto-électrique apte à convertir une variation du champ magnétique en une différence de potentiel entre deux bornes électriques. Le convertisseur est composé d'une part, d'un transducteur électromécanique comprenant une couche piézoélectrique apte à transformer une déformation mécanique en une différence de potentiel entre deux bornes électriques reliées à ses électrodes. Le convertisseur est composé d'autre part d'une couche magnétostrictive fixée selon le plan de référence et sans degré de liberté au transducteur électromécanique, apte à convertir une variation du champ magnétique en une déformation mécanique, exercée sur le transducteur électromécanique.

L'état de la technique ne propose néanmoins pas une configuration de générateur d'électricité simple, efficace et compact.

### OBJET DE L'INVENTION

Un objet de l'invention est de proposer un convertisseur magnéto-électrique adapté à la fabrication d'un générateur électrique simple, efficace et compact.

### BREVE DESCRIPTION DE L'INVENTION

L'invention concerne un convertisseur magnéto-électrique, apte à convertir une variation du champ magnétique en une différence de potentiel entre deux bornes électriques selon la revendication indépendante de dispositif 1. L'efficacité de conversion du convertisseur selon l'invention est liée aux caractéristiques de l'empilement de couches. La présence de la couche support et des moyens de connexion permettent un bon niveau de compacité.

Selon des caractéristiques avantageuses du convertisseur selon l'invention, prises seules ou en combinaison :
- l'empilement de couches comprend une couche de collage entre la première couche et la deuxième couche ;
- les électrodes métalliques de la deuxième couche sont des électrodes interdigitées présentes sur l'une au moins de ses faces ou sur sa tranche ;
- l'empilement de couches comprend une troisième couche en un matériau piézoélectrique présentant un deuxième axe de polarisation dans le plan défini par la troisième couche, la première couche étant disposée entre la deuxième couche et la troisième couche ; le deuxième axe de polarisation étant aligné ou perpendiculaire au premier axe de polarisation, à mieux que 15° près ;
- les électrodes métalliques de la troisième couche sont des électrodes interdigitées présentes sur l'une au moins de ses faces ;
- le matériau piézoélectrique est composé de PZT, de PMN-PT, de PVDF, de BaTiO3 ou d'AlN ;
- le matériau magnétostrictif est composé de Terfenol-D cristallin ou fritté, de Galfenol, de Terbium Fer, de Fer-Cobalt, de Fer-Nickel ou encore de FeSiB amorphe ;
- l'empilement de couches et la couche support ont une forme circulaire ;
- le convertisseur magnéto-électrique présente un diamètre inférieur à 3 cm et un ratio diamètre sur épaisseur supérieur à 3 ;
- la couche support est un circuit imprimé ;
- le circuit imprimé comprend au moins une fonction de commutateur pour récolter les charges générées sur les électrodes ;
- le circuit imprimé comprend au moins une fonction de stockage des charges générées sur les électrodes ;
- le circuit imprimé comprend au moins une fonction de traitement du signal électrique induit par les charges générées sur les électrodes ;
- les moyens de connexion électrique des électrodes aux bornes électriques comprennent au moins deux bandes de matériau adhésif conducteur disposés sur la tranche de l'empilement de couches et sur la tranche ou le bord de la couche support ;
- la tranche de la première couche est séparée des bandes de matériau adhésif conducteur par une couche de matériau adhésif isolant ;
- les moyens de connexion électrique des électrodes aux bornes électriques comprennent au moins deux câblages filaires ;
- les moyens de connexion électrique des électrodes aux bornes électriques comprennent au moins deux vias traversantes conductrices dans l'empilement de couches.
- le convertisseur comprend une couche tampon dont le matériau présente des propriétés d'absorption acoustique et qui est disposée entre l'empilement de couches et la couche support.

L'invention concerne également un générateur d'électricité comprenant :
- un convertisseur magnéto-électrique tel que ci-dessus ;
- une source générant dans le plan de référence un champ magnétique ;
la source de champ magnétique et le convertisseur pouvant se déplacer en rotation l'un par rapport à l'autre de manière à faire varier l'orientation du champ magnétique dans le plan de référence.

Selon des caractéristiques avantageuses du générateur selon l'invention, prises seules ou en combinaison :
- la source de champ magnétique définit un logement dans lequel règne le champ magnétique, le convertisseur étant placé dans le logement ;
- la source de champ magnétique est un cylindre d'Halbach ;

Un procédé de fabrication d'un convertisseur magnéto-électrique comportant :
- une étape de fourniture d'une première couche de matériau magnétostrictif ;
- une étape de fourniture d'une deuxième couche d'un matériau piézoélectrique présentant un premier axe de polarisation dans un plan défini par la deuxième couche et comportant des électrodes ;
- une étape d'assemblage de la première couche avec la deuxième couche pour former l'empilement de couches.

Selon des caractéristiques avantageuses du procédé de fabrication prises seules ou en combinaison :
- le procédé de fabrication d'un convertisseur magnéto-électrique comporte une étape de fourniture d'une troisième couche en un matériau piézoélectrique présentant un deuxième axe de polarisation dans un plan défini par la troisième couche et comportant des électrodes ;
- le procédé de fabrication d'un convertisseur magnéto-électrique comporte une étape d'assemblage de la première couche avec la troisième couche, la première couche étant disposée entre la deuxième couche et la troisième couche ;
- les étapes d'assemblage comprennent le dépôt de colle sur l'une au moins des faces à assembler des couches et la mise en contact desdites faces ;
- le procédé de fabrication d'un convertisseur magnéto-électrique comprend l'assemblage de l'empilement de couches avec une couche support, pour connecter les électrodes de la au moins une couche de matériau piézoélectrique à deux bornes électriques.

### BREVE DESCRIPTION DES DESSINS

D'autres caractéristiques et avantages de l'invention ressortiront de la description détaillée de l'invention qui va suivre en référence aux figures annexées sur lesquelles :
- la figure 1 présente un schéma de principe d'un générateur d'électricité ;
- les figures 2a et 2b présentent une deuxième et une troisième couche en matériau piézoélectrique, adaptées pour le convertisseur magnéto-électrique ;
- les figures 3a à 3f présentent un procédé de fabrication d'un empilement de couches pour un convertisseur magnéto-électrique ;
- les figures 4a à 4c présentent un procédé de fabrication d'un convertisseur ;
- les figures 5a à 5c présentent un schéma de principe du fonctionnement d'un générateur d'électricité compact conforme à l'invention.

### DESCRIPTION DETAILLEE DE L'INVENTION

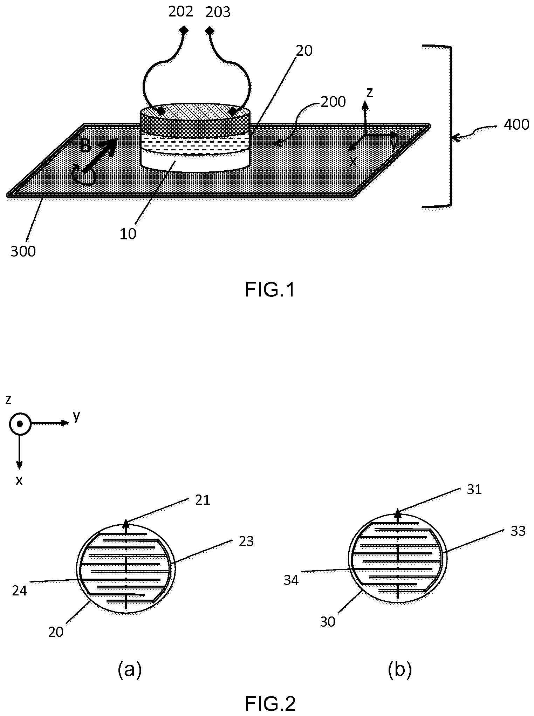

La figure 1 représente un schéma de principe d'un générateur 400 d'électricité. Il comporte une source 300 de champ magnétique et un convertisseur magnéto-électrique 200 apte à convertir une variation du champ magnétique B en une différence de potentiel entre des bornes électriques 202,203. Le convertisseur 200 comprend deux bornes électriques 202,203 et un empilement formé d'une première couche 10 en matériau magnétostrictif définissant un plan de référence (x,y) et d'une deuxième couche 20 en un matériau piézoélectrique. Une partie des lignes du champ magnétique B sont parallèles au plan de référence (x,y). La source 300 de champ magnétique et le convertisseur 200 peuvent se déplacer en rotation l'un par rapport à l'autre de manière à faire varier l'orientation du champ magnétique B dans le plan de référence.

Selon l'invention, pour limiter l'encombrement du générateur 400 (par exemple de l'ordre du centimètre cube), la dimension de la source 300 de champ magnétique est réduite. L'intensité du champ peut être par exemple de l'ordre de 0,3 Tesla, ou compris entre 0,1 et 0,6 Tesla. Le matériau magnétostrictif est choisi pour présenter un coefficient magnétostrictif avantageusement supérieur à 30ppm. Il peut s'agir de Terfenol cristallin ou fritté, de Galfenol, de Terbium Fer, de Fer-Cobalt, de Fer-Nickel ou encore de FeSiB amorphe. Soumis à un champ magnétique B dans le plan de référence (x, y), la première couche (10) de matériau magnétostrictif va subir une déformation selon l'axe parallèle audit champ magnétique B.

Selon un aspect avantageux de l'invention, et pour répondre aux besoins de compacité, la source 300 est munie d'un logement dans lequel règne le champ magnétique B et dans lequel le convertisseur magnéto-électrique 200 est placé. A titre d'exemple, la source 300 de champ magnétique peut être un aimant permanent, par exemple un cylindre de Halbach.

### Empilement de couches formant le convertisseur

Comme on l'a vu en relation avec la figure 1, le convertisseur 200 comprend un empilement formé d'une première couche 10 en matériau magnétostrictif et d'une deuxième couche 20 en un matériau piézoélectrique.

Le procédé de fabrication de l'empilement 100 comprend ainsi la fourniture d'une première couche 10 en matériau magnétostrictif. Il comprend également une étape de fourniture d'une deuxième couche 20 en matériau piézoélectrique présentant un axe de polarisation 21 (nommé « premier axe de polarisation ») dans un plan défini par la deuxième couche 20. L'une au moins des faces de la deuxième couche 20 comporte des électrodes, de préférence des électrodes interdigitées 23,24 (figure 2a). Dans ce cas, son axe de polarisation 21 est parallèle au plan des faces de la deuxième couche 20 et perpendiculaire aux doigts de matériau conducteur formant les électrodes interdigitées 23,24. La couche 20 de matériau piézoélectrique est donc préférentiellement préparée pour fonctionner en mode d₃₃, qui est avantageusement plus sensible que le mode d₃₁, ce qui contribue à améliorer l'efficacité du convertisseur.

Selon une première variante, les électrodes 23,24 pourront être formées par un matériau conducteur en contact avec la face de la deuxième couche 20 ; la pluralité de doigts de chaque électrode pourra être connectée par un segment en arc de cercle, comme illustré sur la figure 2a, dans le cas d'une deuxième couche 20 de forme circulaire.

Selon une deuxième variante, les doigts de chaque électrode pourront être connectés deux à deux par un élément conducteur, par exemple un câblage filaire, au niveau de la face de la deuxième couche 20 ou au niveau de sa tranche : cette configuration permet notamment d'augmenter la dimension des doigts (par exemple jusqu'aux bords de la deuxième couche 20) et donc de développer la partie active de collection de charges sur une surface plus importante de la face de la deuxième couche 20.

Selon une troisième variante, les électrodes 23,24 pourront être formées par un matériau conducteur, disposé dans l'épaisseur de la deuxième couche 20 : chaque doigt d'une électrode présent sur une face de la deuxième couche 20 se prolonge dans l'épaisseur de celle-ci, formant une lame traversante en matériau conducteur. On pourra par exemple faire référence à des techniques de fabrication de multicouches piézoélectriques (« multilayer piezoelectric stack » selon la terminologie anglo-saxonne) pour l'élaboration de la deuxième couche 20 selon cette troisième variante. Cette configuration permet de maximiser l'efficacité de collecte de charges car elle exploite l'intégralité de l'épaisseur de la deuxième couche 20. Cette troisième variante peut incorporer l'un ou l'autre des modes de connexion des doigts de chaque électrode décrits dans les premières et deuxièmes variantes précitées, sans bien sur que cela soit limitatif.

Le procédé de fabrication de l'empilement de couches 100 comprend une étape d'assemblage de la première couche 10 avec la deuxième couche 20. L'étape d'assemblage pourra comprendre, d'une part, l'étalement d'un film ou d'un serpentin de colle 40 sur l'une au moins des deux faces à assembler, respectivement de la première couche 10 ou de la deuxième couche 20.

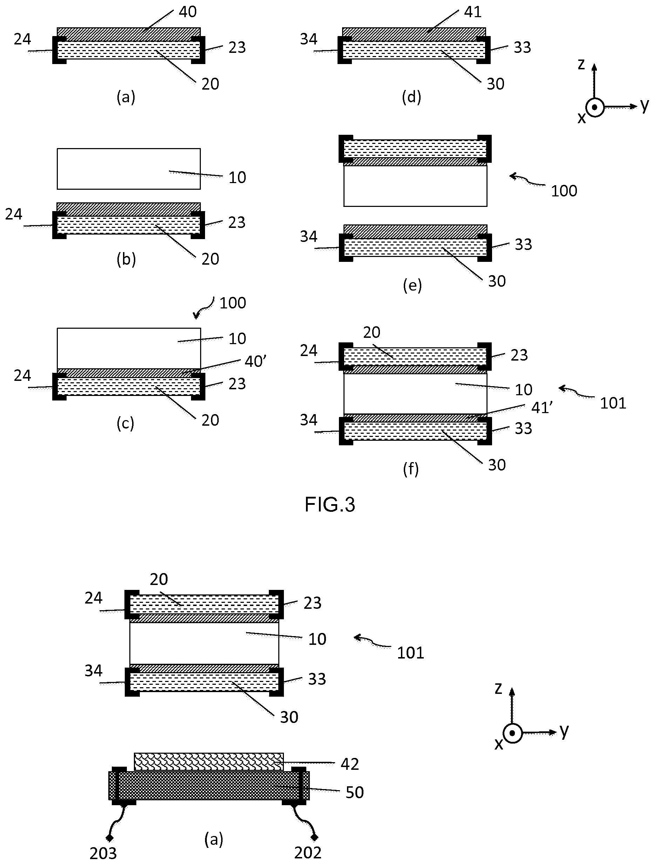

Les figures 3a à 3f présentent un tel exemple de réalisation : le film de colle 40 est étalé sur la deuxième couche 20 (figure 3a) ; la première couche 10 est ensuite amenée en vis-à-vis de la deuxième couche 20 (figure 3b). L'étape d'assemblage comprend ensuite la mise en contact des faces à assembler des couches 10 et 20 (figure 3c). Pour obtenir une couche uniforme de colle 40' à l'interface entre les deux couches, une pression uniforme sera appliquée de manière à rapprocher les deux couches entre elles.

L'empilement de couches 100 est ainsi constitué de la première couche 10 de matériau magnétostrictif assemblée à la deuxième couche 20 de matériau piézoélectrique, cette dernière étant munie d'électrodes 23,24 sur l'une au moins de ses faces.

Selon une variante, le procédé de fabrication d'un empilement de couches 101 comprend une étape de fourniture d'une troisième couche 30 d'un matériau piézoélectrique présentant un axe de polarisation 31 (nommé « deuxième axe de polarisation ») dans un plan défini par la troisième couche 30 (figure 2b). Avantageusement, l'une au moins des faces de la troisième couche 30 comporte des électrodes interdigitées 33,34 et l'axe de polarisation 31 est parallèle au plan desdites faces et en particulier, perpendiculaire aux doigts de matériau conducteur formant les électrodes interdigitées 33,34.

Le procédé de fabrication comporte également une étape d'assemblage de l'empilement de couches 100 avec la troisième couche 30, de sorte que la première couche 10 soit disposée entre la deuxième 20 et la troisième couche 30. L'assemblage se fait donc entre la face libre de la première couche 10 (face opposée à celle assemblée à la deuxième couche 20) et l'une des faces de la troisième couche 30, après étalement du film ou du serpentin de colle 41. A titre d'exemple, le film de colle 41 est déposé sur une face de la troisième couche 30 comme illustré sur la figure 3d. L'assemblage sera avantageusement effectué de sorte que le premier axe de polarisation 21 et le deuxième axe de polarisation 31 soient alignés ou perpendiculaires, par exemple à 15° près. Selon une autre configuration avantageuse, la précision de positionnement du premier axe par rapport au deuxième axe de polarisation pourra même être meilleure que 5°. Le premier axe de polarisation 21 et le deuxième axe de polarisation 31 étant contenus dans des plans sensiblement parallèles (respectivement le plan défini par la deuxième couche 20 et le plan défini par la troisième couche 30), l'alignement entre ces deux axes consiste à limiter l'angle qu'ils forment entre eux, dans une vue planaire (dans le plan des couches). Dis autrement, l'angle que forment les projections de ces axes sur un plan défini par l'une des couches est inférieur à 15° (ou 5°).

L'empilement de couches 101 est ainsi constitué de la première couche 10 de matériau magnétostrictif disposée entre la deuxième 20 et la troisième couche 30 de matériau piézoélectrique, chacune munie d'électrodes 23,24,33,34 sur l'une au moins de leurs faces (figure 3f).

La colle utilisée lors d'une étape d'assemblage pourra être choisie parmi des matériaux de différentes natures dans le but de privilégier certaines caractéristiques de l'empilement de couches 100,101. Le comportement viscoélastique de certains matériaux adhésifs sera avantageux pour absorber les différences de dilatation thermique entre les couches de matériau piézoélectrique 20,30 et la couche de matériau magnétostrictif 10. Des matériaux adhésifs plus durs et rigides seront préférés pour assurer un transfert efficace de la déformation de la première couche 10 vers les deuxième 20 et troisième 30 couches. Une interface de collage autorisant un glissement minimal entre les couches pourra alternativement être élaborée par co-frittage des couches assemblées ou encore par collage direct, sans ajout de matière adhésive.

Sans que cela soit limitatif, le matériau piézoélectrique pourra être choisi parmi le PZT, le PMN-PT, le PVDF, le BaTiO3 ou encore l'AlN.

### Convertisseur magnéto-électrique

Le convertisseur magnéto-électrique 200 selon l'invention est apte à convertir une variation d'un champ magnétique B en une différence de potentiel entre deux bornes électriques 202,203. Il comprend l'un ou l'autre des empilements de couches 100, 101 tels que décrits précédemment.

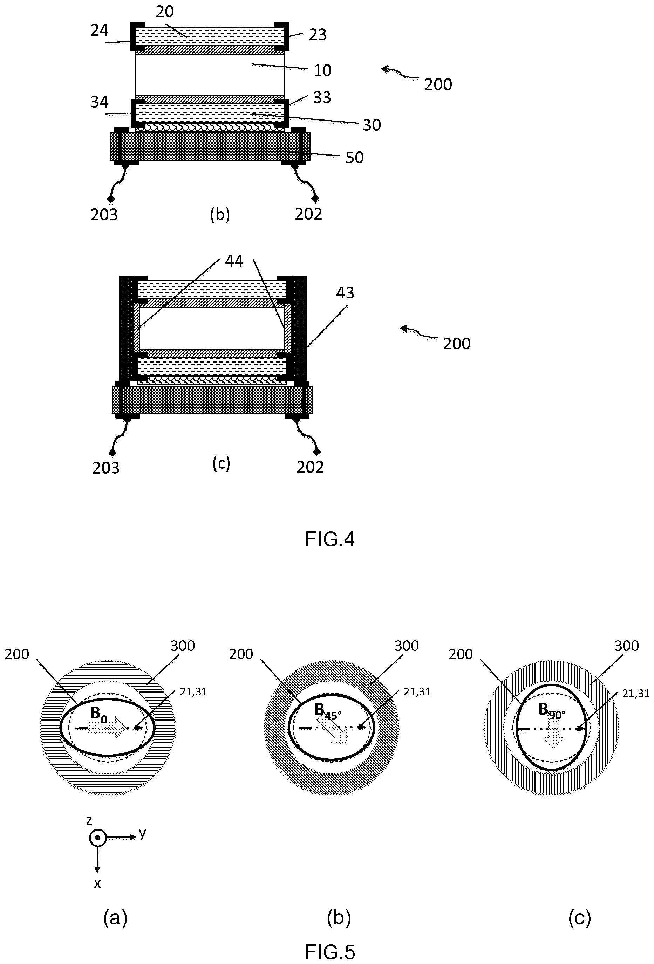

Comme cela est représenté sur les figures 4a à 4c, une borne électrique 202 est électriquement reliée à l'une des électrodes interdigitées 23,33, l'autre borne électrique 203 est reliée à l'autre des électrodes interdigitées 24,34, par l'intermédiaire d'une couche support 50. A titre d'exemple, cette couche support 50 pourra comprendre un circuit imprimé (également appelé PCB pour « printed circuit board »). La couche support 50 pourra être par exemple assemblé via une couche de colle 42 à la face libre de la deuxième 20 ou de la troisième couche 30 de l'empilement de couches 100 ou 101 (figure 4a). Comme illustré sur la figure 4a, la couche support 50 peut comporter des bornes électriques 202,203 au niveau de sa face arrière, sa face avant étant assemblée avec l'empilement de couches 100,101. Ces bornes électriques 202,203 pourront ainsi être ultérieurement connectées sur d'autres éléments, pour l'élaboration du générateur 400.

La connexion électrique entre les électrodes interdigitées 23,24,33,34 et les contacts de la couche support 50 (aptes à être reliées aux deux bornes électriques qui verront la différence de potentiel) pourra être réalisée par l'intermédiaire de bandes de colle conductrice 43 déposées sur la tranche du convertisseur 200, en particulier sur la tranche de l'empilement de couches 100,101 et la tranche ou le bord de la couche support 50. Par tranche, on signifie les surfaces latérales reliant les faces principales des couches, les faces principales étant parallèles au plan (x,y) sur les figures. Les bords de couche correspondent à une partie périphérique sur une face principale. Préalablement, la tranche de la première couche 10 de matériau magnétostrictif aura été recouverte d'un film 44 isolant électriquement, notamment pour éviter que les bandes de colle conductrice 43 soient en court circuit, au contact avec la première couche 10 (figure 4c).

Alternativement, la connexion électrique entre les électrodes interdigitées 23,24,33,34 et les contacts de la couche support 50 pourra être réalisée par l'intermédiaire de câblages filaires (« wire bonding » selon la terminologie anglo-saxonne). Ces câblages filaires pourront aller de la face de la deuxième (et/ou troisième) couche 20 comportant les électrodes ou de sa tranche vers une des faces de la couche support 50 ou sa tranche.

Alternativement, la connexion électrique entre les électrodes interdigitées 23,24,33,34 et les contacts de la couche support 50 pourra être réalisée au moyen de vias conductrices traversant l'empilement de couches (100,101).

La couche support 50 aura avantageusement une forme similaire à celle de l'empilement de couches 100,101, par exemple une forme circulaire. Selon une variante, elle pourra être assemblée à un deuxième circuit imprimé comprenant des fonctions de commutation pour récolter les charges générées sur les électrodes (23,24,33,34), de stockage desdites charges et/ou de traitement du signal électrique induit.

Selon une autre variante avantageuse, la couche support 50 pourra elle-même comprendre au moins une fonction de commutateur pour récolter les charges générées sur les électrodes (23,24,33,34). Elle pourra également comprendre au moins une fonction de stockage des charges générées sur les électrodes (23,24,33,34). Elle pourra également comprendre au moins une fonction de traitement du signal électrique induit par les charges générées sur les électrodes (23,24,33,34).

Selon encore une autre variante avantageuse, une couche tampon, composée d'au moins un matériau présentant des propriétés d'absorption acoustique, est disposée entre l'empilement de couches 100,101 et la couche support 50. Cette couche tampon est assemblée, d'une part avec l'empilement 100,101 et d'autre part avec la couche support 50, via une couche de colle.

Dans le convertisseur 200, la couche tampon aura pour rôle d'absorber les ondes acoustiques qui peuvent générées par le brusque changement de forme et/ou ou d'état de contrainte de la deuxième (et/ou troisième) couche en matériau piézoélectrique 20,30 qui peut s'opérer au moment de la récupération des charges sur les bornes du convertisseur 200 (la collecte des charges sera plus particulièrement abordée ci-après lors de la description du générateur). Ces ondes acoustiques se traduisent par un cliquetis audible à chaque récupération de charges et qui peut être gênant pour certaines applications. La couche tampon permet d'absorber ce son ou au moins de l'amortir significativement, éliminant ou atténuant ainsi le désagrément sonore.

Sans toutefois que cela soit limitatif, la couche tampon est avantageusement composée d'un matériau alvéolaire, en particulier à alvéoles ouvertes. A titre d'exemple, un matériau tel que la mousse de polyuréthane pourra être utilisé.

### Générateur électrique

Pour former le générateur d'électricité 400, le convertisseur magnéto-électrique 200 peut être placé dans un logement défini par une source 300 de champ magnétique, et dans lequel règne un champ magnétique B, une partie des lignes du champ étant contenue dans un plan de référence défini par la première couche 10 en matériau magnétostrictif du convertisseur 200. Le convertisseur 200 a avantageusement une forme circulaire, un diamètre inférieur à 3 cm et un ratio diamètre sur épaisseur supérieur à 3. On forme de la sorte un générateur 400 particulièrement compact. La source 300 de champ magnétique et le convertisseur 200 peuvent se déplacer en rotation l'un par rapport à l'autre de manière à faire varier l'orientation du champ magnétique B dans le plan de référence. Le convertisseur 200 est donc pénétré par un champ magnétique B, préférentiellement uniforme, et orienté selon une direction initiale *̅B̅*̅₀ dans le plan de référence (x, y). La variation de ce champ magnétique est destinée à être convertie en différence de potentiel entre les deux bornes électriques 202,203 du convertisseur 200.

Avantageusement, on positionnera le convertisseur dans le logement de la source 300 de champ pour que la direction initiale *̅B̅*̅₀ du champ soit parallèle ou perpendiculaire au premier 21 et/ou au deuxième 31 axe de polarisation, respectivement de la deuxième 20 et de la troisième 30 couche en matériau piézoélectrique.

Comme illustré sur la figure 5a, sous l'action du champ magnétique *̅B̅*̅₀, la première couche 10 de matériau magnétostrictif se magnétise et subit une déformation selon l'axe y, parallèle au champ magnétique *̅B̅*̅₀. Cette déformation correspond à une extension de l'empilement de couches 100,101 dans le plan de référence selon l'axe y (parallèle aux axes de polarisation 21,31 selon l'exemple illustré sur la figure 5a), que l'on appellera extension maximale par la suite. L'empilement de couches 100,101 subit en même temps une contraction (soit une extension négative, que l'on appellera par la suite « extension minimale ») dans le plan de référence (x,y) selon l'axe x. La déformation de la première couche 10 est schématisée sur la figure 5a par l'ovalisation du convertisseur 200 selon l'axe y. Cette déformation s'applique à la deuxième couche 20 (et, si elle est présente, à la troisième couche 30) et correspond à un état initial du convertisseur 200.

Pour réaliser une variation du champ magnétique, on fait par exemple tourner son orientation de la direction initiale *̅B̅*̅₀ jusqu'à une direction *̅B̅*̅_{45°}, dans le sens des aiguilles d'une montre (comme illustré sur la figure 5b), en déplaçant en rotation la source de champ 300. Alternativement, on pourra opérer un déplacement en rotation du convertisseur 200. En conséquence, l'empilement de couches 100,101 du convertisseur 200 passe de son état initial à un deuxième état dans lequel :
- la première couche 10 va se rétracter selon l'axe y, passant d'une extension maximale à une extension moyenne plus faible, du fait de la diminution de la composante du champ magnétique B selon l'axe y ;
- la première couche 10 va par ailleurs s'étendre selon l'axe x, passant d'une extension minimale (contraction maximale) à une extension moyenne plus importante.

La variation du champ magnétique (par une rotation de sa direction) induit donc des variations de déformation de la première couche 10. Celle-ci transmet ces variations à la deuxième 20 (et potentiellement la troisième 30) couche, assemblée(s) à la première couche 10 dans l'empilement de couches 100,101.

Si on continue à faire tourner l'orientation du champ magnétique de la direction *̅B̅*̅_{45°}, jusqu'à la direction *̅B̅*̅_{90°} dans le sens des aiguilles d'une montre (comme illustré sur la figure 5c), l'empilement de couches 100,101 va passer du deuxième état à un troisième état dans lequel :
- la première couche se rétracte encore selon l'axe y, passant d'une extension moyenne à une extension minimale (rétraction maximale);
- la première couche s'étend selon l'axe x, passant d'une extension moyenne à une extension maximale selon l'axe x, compte tenu de l'alignement du champ magnétique avec cet axe.

La variation du champ magnétique B entre la position initiale et la troisième position a donc induit des variations de déformation de la première couche 10, transmises à la deuxième 20 (et potentiellement la troisième 30) couche. Les deuxième 20 et troisième 30 couches de matériau piézoélectrique fonctionnent en mode d₃₃, c'est-à-dire que l'axe de polarisation est dans le plan de la couche et donc que la génération de charges dans le matériau est sensible à des déformations dans ce même plan.

Dans le cas du convertisseur 200 selon la configuration avantageuse décrite de l'invention, la deuxième 20 et la troisième 30 couches subissent le long de leur axe de polarisation 21,31, entre l'état initial et le troisième état, une déformation maximale en passant d'une extension maximale à une extension minimale (rétraction maximale). Une quantité maximale de charges (par exemple négatives) pourra donc être accumulée sur l'une des électrodes interdigitées (par exemple 23,33) et être collectée au niveau de l'une des bornes électriques du générateur, par exemple, sur un dispositif capacitif.

Cette première séquence de variation du champ magnétique (de *̅B̅*̅₀ à *̅B̅*̅_{90°}), faisant passer le convertisseur 200 de l'état initial au troisième état peut ainsi générer une différence de potentiel entre les bornes électriques 202,203 : cette différence de potentiel est importante grâce à la configuration du convertisseur 200 selon l'invention, garantissant une bonne efficacité du convertisseur 200, dans une configuration compacte de générateur d'électricité 400.

Après la collecte des charges au troisième état, la différence de potentiel entre les bornes électriques 202,203 est nulle et la structure de convertisseur 200 se retrouve dans un quatrième état considéré comme un nouvel état initial. La variation du champ magnétique (de *̅B̅*̅_{90°} jusqu'à *̅B̅*̅_{180°}), dans le sens des aiguilles d'une montre, va faire passer l'empilement de couches 100,101 d'un quatrième état initial à un cinquième état dans lequel :
- la première couche s'étend selon l'axe y, passant d'une extension minimale à une extension maximale, compte tenu de l'alignement du champ avec cet axe.
- la première couche se rétracte selon l'axe x, passant d'une extension maximale à une extension minimale (rétraction maximale).

La deuxième 20 (et si elle est présente, la troisième 30) couche subit le long de son axe de polarisation 21,31, entre le quatrième état initial et le cinquième état, une déformation maximale en passant d'un état d'extension minimale à un état d'extension maximale. Une quantité maximale de charges (par exemple positives) pourra donc être accumulée sur l'autre des électrodes interdigitées 24,34 et être collectée au niveau de l'autre des bornes électriques du générateur.

L'invention propose ainsi un générateur d'électricité 400, compact comprenant un convertisseur magnéto-électrique efficace, apte à générer une quantité importante de charges, tous les quarts de tours d'un mouvement rotatif relatif entre la source 300 de champ magnétique et le convertisseur 200.

Dans certains cas, la source 300 de champ magnétique est avantageusement choisie de sorte que l'intensité du champ magnétique uniforme qui règne dans le logement soit inférieure à l'intensité nécessaire pour saturer magnétiquement le matériau de la première couche 10 magnétostrictive. Le générateur d'électricité 400 selon l'invention peut présenter ainsi l'avantage d'une robustesse améliorée. En effet, le convertisseur 200 montre une tenue mécanique aux cycles de déformation plus importante du fait que la première couche 10 en matériau magnétostrictif ne travaille pas dans un mode de saturation magnétique. La longévité en termes de cycles de déformation des convertisseurs 200 selon l'invention peut être augmentée d'un facteur 10 à 1000 par rapport à des convertisseurs fonctionnant en saturation magnétique dans un générateur. Par ailleurs, la faible intensité du champ magnétique permet de limiter l'amplitude d'un couple parasite pouvant s'appliquant sur le convertisseur tendant à placer son axe préférentiel de déformation dans l'alignement du champ, lorsque le matériau magnétostrictif composant ce convertisseur n'est pas isotrope.

### Exemple de mise en œuvre

Selon un exemple de mise en œuvre de l'invention, l'empilement de couches 101 est formé par assemblage d'une deuxième couche 20 et d'une troisième couche 30 de PZT, sur chacune des faces d'une première couche 10 de Terfenol-D. La couche 10 a par exemple une dimension circulaire, une épaisseur de 1 mm et un diamètre de 2 cm. Chaque couche de PZT a une épaisseur par exemple de 100 microns et un diamètre de 2 cm. Dans cet exemple de mise en œuvre, chaque deuxième 20 et troisième 30 couche comporte des électrodes interdigitées 23,24,33,34 sur chacune de ses faces. Une telle configuration permet de favoriser l'efficacité de génération de charges en réponse à une déformation. Ces électrodes se présentent sous forme de peignes ; les doigts des peignes sont perpendiculaires à l'axe de polarisation du matériau. La deuxième 20 et la troisième 30 couche de PZT comportent respectivement un premier 21 et deuxième 31 axes de polarisation dans le plan de la couche. Une couche de colle 40 non conductrice électrique est déposé sur la face à assembler de la deuxième couche 20 ; la première couche 10 est positionnée au-dessus, en vis-à-vis. Une pression est ensuite appliquée pour mettre en contact la première 10 et la deuxième 20 couche et étaler uniformément à l'interface la couche de colle 40. L'empilement de couches 100 est ainsi formé.

Une couche de colle 41 non conductrice électrique est ensuite déposée sur la face à assembler de la troisième couche 30 ; l'empilement de couches 100 est positionné au-dessus, la face libre de la première couche 10 en vis-à-vis avec la face encollée de la troisième couche 30. L'alignement entre le premier axe de polarisation 21 et le deuxième axe de polarisation 31 peut être réalisé en alignant par exemple optiquement les peignes des électrodes 23,24 et 33,34. On peut également, pour permettre cet alignement, faire porter une marque par l'une et l'autre des électrodes, en leur donnant localement une forme qui peut être facilement repérée.

Une pression est ensuite appliquée pour mettre en contact les faces à coller et répartir uniformément à l'interface la couche de colle. La précision d'alignement permet d'obtenir un alignement entre les deux axes de polarisation 21,31 à mieux que 15°. Alternativement, comme évoqué précédemment, les axes de polarisation pourraient être positionnés à 90° l'un par rapport à l'autre dans l'empilement de couches 101.

Un circuit imprimé 50 (couche support), de diamètre 2 cm et d'épaisseur de quelques centaines de microns est ensuite encollé (couche de colle 42) sur une de ses faces pour être assemblé à la face libre, par exemple, de la troisième couche 30.

Un film de colle 44 ou autre matériau non conducteur électrique est déposé pour protéger et isoler la tranche de la première couche 10 de Terfenol. Des bandes de matériau conducteur 43 (par exemple colle conductrice) sont ensuite déposées pour connecter électriquement les bornes électriques 202,203 du circuit imprimé 50 et les électrodes interdigitées 23,24,33,34 des deux couches 20,30 de PZT.

Le convertisseur magnéto-électrique 200 peut ensuite générer une différence de potentiel entre les bornes électriques 202,203, par application de variations de champ magnétique B, par exemple par l'utilisation d'un champ de direction tournante. Le générateur d'électricité 400 comporte de préférence une source 300 de champ magnétique définissant un logement à l'intérieur duquel règne un champ magnétique ; l'intensité du champ magnétique est préférentiellement choisie inférieure à l'intensité menant à la saturation magnétique de la première couche 10 magnétostrictive. Le convertisseur magnéto-électrique est disposé dans ce logement, environné dudit champ magnétique. Un mouvement de rotation relatif entre le convertisseur 200 et la source 300 de champ magnétique permet de générer la variation du champ.

L'invention n'est pas limitée aux modes de réalisation décrits et on peut y apporter des variantes de réalisation sans sortir du cadre de l'invention tel que défini par les revendications.

## Revendications

1. Convertisseur magnéto-électrique (200), apte à convertir une variation du champ magnétique (B) en une différence de potentiel entre deux bornes électriques (202,203) ; le convertisseur incluant un empilement d'une première couche (10) en un matériau magnétostrictif définissant un plan de référence et d'une deuxième couche (20) en un matériau piézoélectrique présentant un premier axe de polarisation (21) dans le plan défini par la deuxième couche (20), parallèle au plan de référence; la deuxième couche (20) comportant des électrodes (23, 24) ; le convertisseur étant **caractérisé en ce qu'**il comprend :
∘ une couche support (50) comprenant les deux bornes électriques (202,203) ;
∘ l'empilement (100,101) disposé sur la couche support (50),
∘ des moyens de connexion électrique (43) des électrodes (23, 24) aux bornes électriques (202,203).

2. Convertisseur magnéto-électrique (200) selon la revendication précédente, dans lequel les électrodes métalliques (23,24) de la deuxième couche (20) sont des électrodes interdigitées présentes sur l'une au moins de ses faces ou sur sa tranche.

3. Convertisseur magnéto-électrique (200) selon l'une des revendications précédentes, dans lequel l'empilement de couches (101) comprend une troisième couche (30) en un matériau piézoélectrique présentant un deuxième axe de polarisation (31) dans le plan défini par la troisième couche (30), la première couche (10) étant disposée entre la deuxième couche (20) et la troisième couche (30) ; le deuxième axe de polarisation (31) étant aligné avec le premier axe de polarisation (21) ou perpendiculaire au premier axe de polarisation (21), à 15° près.

4. Convertisseur magnéto-électrique (200), selon la revendication précédente, dans lequel les électrodes métalliques (33,34) de la troisième couche (30) sont des électrodes interdigitées présentes sur l'une au moins de ses faces.

5. Convertisseur magnéto-électrique (200), selon l'une des revendications précédentes, dans lequel le matériau piézoélectrique est composé de PZT, de PMN-PT, de PVDF, de BaTiO3 ou d'AlN.

6. Convertisseur magnéto-électrique (200), selon l'une des revendications précédentes, dans lequel le matériau magnétostrictif est composé de Terfenol-D cristallin ou fritté, de Galfenol, de Terbium Fer, de Fer-Cobalt, de Fer-Nickel ou encore de FeSiB amorphe.

7. Convertisseur magnéto-électrique (200), selon l'une des revendications précédentes, dans lequel l'empilement de couches (100,101) et la couche support (50) ont une forme circulaire.

8. Convertisseur magnéto-électrique (200), selon la revendication précédente, présentant un diamètre inférieur à 3 cm et un ratio diamètre sur épaisseur supérieur à 3.

9. Convertisseur magnéto-électrique (200), selon l'une des revendications précédentes, dans lequel la couche support (50) est un circuit imprimé.

10. Convertisseur magnéto-électrique (200), selon la revendication précédente, dans lequel le circuit imprimé (50) comprend au moins une fonction de commutateur pour récolter les charges générées sur les électrodes (23,24,33,34).

11. Convertisseur magnéto-électrique (200), selon l'une des deux revendications précédentes, dans lequel le circuit imprimé (50) comprend au moins une fonction de stockage des charges générées sur les électrodes (23,24,33,34).

12. Convertisseur magnéto-électrique (200), selon l'une des trois revendications précédentes, dans lequel le circuit imprimé (50) comprend au moins une fonction de traitement du signal électrique induit par les charges générées sur les électrodes (23,24,33,34).

13. Générateur d'électricité (400) comprenant :
• un convertisseur magnéto-électrique (200) selon l'une des douze revendications précédentes ;
• une source (300) générant dans le plan de référence un champ magnétique (B) ;
la source (300) de champ magnétique et le convertisseur (100) pouvant se déplacer en rotation l'un par rapport à l'autre de manière à faire varier l'orientation du champ magnétique (B) dans le plan de référence.

14. Générateur d'électricité (400) selon la revendication précédente dans lequel la source (300) de champ magnétique définit un logement dans lequel règne le champ magnétique (B), le convertisseur (200) étant placé dans le logement.

15. Générateur d'électricité (400) selon l'une des deux revendications précédentes, dans lequel la source (300) de champ magnétique est un cylindre d'Halbach.

## Patentansprüche

1. Magneto-elektrischer Wandler (200), der dazu geeignet ist, eine Änderung des Magnetfeldes (B) in eine Potentialdifferenz zwischen zwei elektrischen Anschlüssen (202, 203) umzuwandeln;
wobei der Wandler einen Stapel aus einer ersten Schicht (10) aus magnetostriktivem Material, die eine Bezugsebene definiert, und einer zweiten Schicht (20) aus piezoelektrischem Material mit einer ersten Polarisationsachse (21) in der durch die zweite Schicht (20) definierten Ebene parallel zur Bezugsebene umfasst;
wobei die zweite Schicht (20) Elektroden (23, 24) umfasst;
wobei der Wandler **dadurch gekennzeichnet ist, dass** er Folgendes umfasst:
∘ eine Trägerschicht (50), umfassend die beiden elektrischen Anschlüsse (202, 203);
∘ den Stapel (100,101), der auf der Trägerschicht (50) angeordnet ist,
∘ Vorrichtungen für die elektrische Verbindung (43) der Elektroden (23, 24) mit den elektrischen Anschlüssen (202, 203).

2. Magneto-elektrischer Wandler (200) nach dem vorhergehenden Anspruch, wobei die Metallelektroden (23, 24) der zweiten Schicht (20) Interdigitalelektroden sind, die auf mindestens einer ihrer Flächen oder an ihrem Rand vorhanden sind.

3. Magneto-elektrischer Wandler (200) nach einem der vorhergehenden Ansprüche, wobei der Schichtstapel (101) eine dritte Schicht (30) aus einem piezoelektrischen Material mit einer zweiten Polarisationsachse (31) in der durch die dritte Schicht (30) definierten Ebene umfasst, wobei die erste Schicht (10) zwischen der zweiten Schicht (20) und der dritten Schicht (30) angeordnet ist;
wobei die zweite Polarisationsachse (31) mit der ersten Polarisationsachse (21) ausgerichtet ist oder innerhalb von 15° senkrecht zur ersten Polarisationsachse (21) steht.

4. Magneto-elektrischer Wandler (200) nach dem vorhergehenden Anspruch, wobei die Metallelektroden (33, 34) der dritten Schicht (30) Interdigitalelektroden sind, die auf mindestens einer ihrer Flächen vorhanden sind.

5. Magneto-elektrischer Wandler (200) nach einem der vorhergehenden Ansprüche, wobei das piezoelektrische Material aus PZT, PMN-PT, PVDF, BaTiO3 oder AIN besteht.

6. Magneto-elektrischer Wandler (200) nach einem der vorhergehenden Ansprüche, wobei das magnetostriktive Material aus kristallinem oder gesintertem Terfenol-D, Galfenol, Terbium-Eisen, Eisen-Kobalt, Eisen-Nickel oder amorphem FeSiB zusammengesetzt ist.

7. Magneto-elektrischer Wandler (200) nach einem der vorhergehenden Ansprüche, wobei der Schichtstapel (100, 101) und die Trägerschicht (50) eine kreisförmige Form besitzen.

8. Magneto-elektrischer Wandler (200) nach dem vorhergehenden Anspruch mit einem Durchmesser von weniger als 3 cm und einem Verhältnis von Durchmesser zu Dicke von mehr als 3.

9. Magneto-elektrischer Wandler (200) nach einem der vorhergehenden Ansprüche, wobei die Trägerschicht (50) eine Leiterplatte ist.

10. Magneto-elektrischer Wandler (200) nach dem vorhergehenden Anspruch, wobei die Leiterplatte (50) mindestens eine Schaltfunktion zum Sammeln der an den Elektroden (23, 24, 33, 34) erzeugten Ladungen aufweist.

11. Magneto-elektrischer Wandler (200) nach einem der beiden vorhergehenden Ansprüche, wobei die Leiterplatte (50) mindestens eine Funktion zum Speichern von auf den Elektroden (23, 24, 33, 34) erzeugten Ladungen umfasst.

12. Magneto-elektrischer Wandler (200) nach einem der drei vorhergehenden Ansprüche, wobei die Leiterplatte (50) mindestens eine Funktion zur Verarbeitung des elektrischen Signals umfasst, das durch die an den Elektroden (23, 24, 33, 34) erzeugten Ladungen induziert wird.

13. Stromgenerator (400), umfassend:
• einen magneto-elektrischen Wandler (200) nach einem der vorhergehenden zwölf Ansprüche;
• eine Quelle (300), die ein Magnetfeld (B) in der Bezugsebene erzeugt;
wobei die Quelle (300) des Magnetfeldes und der Wandler (100) relativ zueinander drehbar sind, um die Orientierung des Magnetfeldes (B) in der Bezugsebene zu variieren.

14. Stromgenerator (400) nach dem vorhergehenden Anspruch, wobei die Quelle (300) des Magnetfeldes ein Gehäuse definiert, in dem das Magnetfeld (B) vorherrscht, wobei der Wandler (200) in dem Gehäuse angeordnet ist.

15. Stromgenerator (400) nach einem der beiden vorhergehenden Ansprüche, wobei die Quelle (300) des Magnetfeldes ein Halbach-Zylinder ist.

## Claims

1. Magneto-electric converter (200) for converting a variation in a magnetic field (B) into a potential difference between two electrical terminals (202, 203);
the converter including a stack of a first layer (10) made of a magnetostrictive material defining a reference plane, and of a second layer (20) made of a piezoeletric material having a first polarization axis (21) in the plane defined by the second layer (20) parallel to the reference plane;
the second layer (20) comprising electrodes (23, 24);
the converter being **characterized in that** it comprises:
∘ a support layer (50) comprising the two electrical terminals (202, 203);
∘ the stack (100, 101) arranged on the support layer (50);
∘ means (43) for electrically connecting the electrodes (23, 24) to the electrical terminals (202, 203).

2. Magneto-electric converter (200) according to the preceding claim, wherein the metal electrodes (23, 24) of the second layer (20) are interdigitated electrodes present on at least one of its faces or on its side surface.

3. Magneto-electric converter (200) according to any one of the preceding claims, wherein the stack of layers (101) comprises a third layer (30) made of a piezoelectric material having a second polarization axis (31) in the plane defined by the third layer (30), the first layer (10) being arranged between the second layer (20) and the third layer (30);
the second polarization axis (31) being aligned with the first polarization axis (21) or perpendicular to the first polarization axis (21), to within 15°.

4. Magneto-electric converter (200) according to the preceding claim, wherein the metal electrodes (33, 34) of the third layer (30) are interdigitated electrodes present on at least one of its faces.

5. Magneto-electric converter (200) according to any one of the preceding claims, wherein the piezoelectric material is composed of PZT, PMN-PT, PVDF, BaTiO3 or AIN.

6. Magneto-electric converter (200) according to any one of the preceding claims, wherein the magnetostrictive material is composed of crystalline or sintered terfenol-D, galfenol, terbium iron, iron-cobalt, iron-nickel or even amorphous FeSiB.

7. Magneto-electric converter (200) according to any one of the preceding claims, wherein the stack of layers (100, 101) and the support layer (50) have a circular shape.

8. Magneto-electric converter (200) according to the preceding claim, having a diameter of less than 3 cm and a diameter-to-thickness ratio of more than 3.

9. Magneto-electric converter (200) according to any one of the preceding claims, wherein the support layer (50) is a printed circuit.

10. Magneto-electric converter (200) according to the preceding claim, wherein the printed circuit (50) comprises at least one switch function for collecting the charges generated on the electrodes (23, 24, 33, 34).

11. Magneto-electric converter (200) according to any one of the two preceding claims, wherein the printed circuit (50) comprises at least one function for storing the charges generated on the electrodes (23, 24, 33, 34).

12. Magneto-electric converter (200) according to any one of the three preceding claims, wherein the printed circuit (50) comprises at least one function for processing the electrical signal induced by the charges generated on the electrodes (23, 24, 33, 34).

13. Electric generator (400), comprising:
• a magneto-electric converter (200) according to any one of the twelve preceding claims;
• a source (300) generating a magnetic field (B) in the reference plane;
the source (300) of the magnetic field and the converter (100) being able to rotate with respect to one another so as to vary the orientation of the magnetic field (B) in the reference plane.

14. Electric generator (400) according to the preceding claim, wherein the source (300) of the magnetic field defines a housing, in which the magnetic field (B) prevails, the converter (200) being placed in the housing.

15. Electric generator (400) according to any one of the two preceding claims, wherein the source (300) of the magnetic field is a Halbach cylinder.
